# EUROPÄISCHE PATENTSCHRIFT

(11) **EP 0 844 808 B1**
(45) Veröffentlichungstag und Bekanntmachung des Hinweises auf die Patenterteilung: **13.08.2003**
(21) Anmeldenummer: 97120236.1
(22) Anmeldetag: 19.11.1997
(51) Int. Cl.: H05K 1/02, H05K 7/20

(54) **Leiterplattenanordnung**
Printed circuit board device
Dispositif pour circuit imprimé

(30) Priorität: 20.11.1996 DE 19647916
(43) Veröffentlichungstag der Anmeldung: 27.05.1998
(73) Patentinhaber: ILFA Industrieelektronik und Leiterplattenfertigung aller Art GmbH, 30559 Hannover (DE)
(72) Erfinder: Süllau,Walter, 38100 Braunschweig (DE); Ilgen,Hermann, 01738 Dorfhain (DE); Schütze,Jörg, 01738 Dorfhain (DE)
(74) Vertreter: Patentanwälte Thömen & Körner

(56) Entgegenhaltungen:
- DE-A- 4 012 100
- DE-A- 19 506 091
- US-A- 4 734 315
- US-A- 5 087 505

## Beschreibung

Die Erfindung betrifft eine Leiterplattenanordnung mit mindestens zwei Leiterplatten, die einseitig oder beidseitig mit elektrischen Leiterbahnen versehen und mit Wärme erzeugenden Bauelementen bestückt sind, mit mindestens einer Kühlplatte, die zu beiden Seiten über eine elektrisch isolierende Klebeschicht mit mindestens einer Leiterplatte verbunden ist, wobei die Kühlplatte mit mindestens einem Kühlkanal versehen ist.

In ihrer einfachsten Ausführungsform umfassen Leiterplattenanordnungen eine Leiterplatte, die in gedruckter Schaltungstechnik auf ihrer einen Seite mit elektrischen Leiterbahnen versehen ist. Auf der Bestückungsseite einer solchen Leiterplatte werden die Bauelemente angeordnet, und die andere Seite der Leiterplatte ist die Lötseite zur Befestigung der Bauelemente und zum Herstellen der erforderlichen elektrischen Verbindungen zwischen den Bauelementen.

In den meisten Fällen werden jedoch bei einer Leiterplattenanordnung mehrere übereinander angeordnete Leiterplatten verwendet, die einseitig oder beidseitig mit elektrischen Leiterbahnen versehen sind und einen sogenannten Multi-Layer bilden. Dabei befinden sich zwischen den einzelnen Leiterplatten Isolierplatten, die in der Fachsprache als Prepreg bezeichnet werden und üblicherweise aus einem in Harz getränktem Glasseidengewebe bestehen (FR4-Material). Der Zweck eines solchen Prepregs besteht darin, elektrische Kurzschlüsse zwischen den einzelnen Leiterplatten zu verhindern, und die Leiterplatten miteinander zu verbinden, um einen Multi-Layer als eine Einheit zu erhalten.

Die auf einer Leiterplattenanordnung befindlichen elektrischen Bauelemente erzeugen im Betrieb Wärme, so daß es erforderlich ist, eine Kühlung vorzusehen, um die Bauelemente vor einer Zerstörung zu schützen und um einen ordnungsgemäßen Betrieb der gesamten elektrischen Schaltung zu ermöglichen. Dieses gilt insbesondere dann, wenn sich auf der Leiterplattenanordnung Leistungsbauelemente befinden, die besonders viel Wärme erzeugen.

Eine bekannte Maßnahme für die Kühlung besteht in der Verwendung eines Kühlkörpers, der mit dem Wärme erzeugenden Bauelement verbunden ist und in vielen Fällen Kühlrippen besitzt, um insgesamt eine große kühlende Oberfläche zu erhalten, welche die Wärme an die Umgebungsluft abgeben kann. Diese Art der Kühlung ist jedoch sehr aufwendig und außerdem nicht besonders wirksam. Die Kühlkörper müssen an die betreffenden Bauelemente angepaßt werden und beanspruchen weitaus mehr Platz als das betreffende Bauelement selbst. Durch die ständige Wärmeabgabe des Kühlkörpers erhöht sich ferner die Temperatur der Umgebungsluft selbst, wodurch der Wirkungsgrad einer solchen passiven Kühlung schlechter wird. Der große Platzbedarf der bekannten Kühlkörper mit Kühlrippen steht im übrigen dem mit der Verwendung von gedruckten Leiterplatten angestrebten Ziel einer Minituriarisierung der gesamten Schaltungsanordnung entgegen.

Durch die europäische Patentschrift EP 0 590 354 B1 ist eine Anordnung mit einer Leiterplatte, mindestens einem Leistungsbauelement und einem Kühlkörper bekannt, bei welcher die in dem Leistungsbauelement erzeugte Wärme und Verlustleistung potentialfrei an den Kühlkörper abgeführt werden kann. Dabei sind dem Leistungsbauelement auf beiden Seiten einer Leiterplatte großflächige Leiterbahnen zugeorndet, die über Durchkontaktierungen wärmeleitend miteinander verbunden sind. Zwischen der unteren großflächigen Leiterbahn und dem Kühlkörper ist eine aus Kupfer bestehende Metallschicht angeordnet, und zur potentialmäßigen Trennung des Leistungsbauelements von dem Kühlkörper ist zwischen der unteren großflächigen Leiterbahn und der Metallschicht aus Kupfer eine Glasgewebeschicht vorgesehen.

Auch diese bekannte passive Kühlung setzt einen im Vergleich zum Leistungsbauelement um ein Vielfaches größeren Kühlkörper voraus, wobei zur potentialfreien Abführung der Wärme an den Kühlkörper noch die beschriebene Glasgewebeschicht sowie die Metallschicht erforderlich sind.

Durch das deutsche Gebrauchsmuster G 93 20 574.0 ist eine Anordnung zum verbessern des Wärmeüberganges zwischen einem elektrischen Bauelement und einer Wärmesenke bekannt, bei welcher eine dicke Kühlplatte auf der Bestückungsseite einer Leiterplatte angeordnet wird. Die Leiterplatte mit den darauf befindlichen Bauelementen wird durch die Einwirkung der Kraft einer Vielzahl von Federn gegen die Kühlpatte gedrückt, und auf den Bauelementen sind beidseitig beschichtete Keramikplatten angeordnet. Durch die Federn werden somit die Oberflächen der elektrischen Bauelemente auf die eine Beschichtung der Keramikplatte gedrückt, die ihrerseits mit der anderen Beschichtung auf die Kühlplatte gedrückt wird, wodurch der Wärmeübergang von den elektrischen Bauelementen auf die Kühlplatte erfolgt. Die Kühlplatte besitzt in ihrem Innern ein Rohrsystem für ein Kühlmittel.

Der Aufbau der bekannten Anordnung ist wegen der benötigten Federn und der beidseitig beschichteten Keramikplatten sehr aufwendig. Sie kann außerdem nur bei einer Leiterplatte angewendet werden. Zur Kühlung einer Leiterplattenanordnung mit mehreren ein- oder beidseitig bedruckten Leiterplatten (Multi-Layer) ist die Anordnung nicht geeignet.

In dem Dokument US 4 718 163 ist ein Verfahren zur Herstellung einer Kühleinrichtung zur Kühlung von Leiterplatten beschrieben. Die bekannte Kühleinrichtung besteht aus einer Kupferplatte, die über ihren Querschnitt verteilt eine Vielzahl nebeneinander liegender Kanäle aufweist. Sowohl auf der Ober- als auch auf der Unterseite der Kühleinrichtung läßt sich jeweils eine Leiterplatte anordnen. Da die Oberflächen der Kühleinrichtung durch Metall gebildet sind, ist es erforderlich, sowohl die Bauelemente als auch die elektrischen Verbindungen jeweils auf der der Metalloberfläche gegenüberliegenden Seite der Leiterplatte anzuordnen, die deshalb nur einseitig bestückt werden können.

Für den Fall, daß die Herstellung elektrischer Kontakte von der einen zur anderen Leiterplatte erforderlich ist, wird in der US-PS 4 718 163 eine gesonderte Kühleinrichtung beschrieben, die so hergestellt wird, daß zwischen benachbarten Kanälen jeweils eine gleich große Aussparung vorhanden ist. Gleichwohl können auch in diesem Fall die beiden Leiterplatten nur einseitig bestückt werden. Im übrigen ist das Verfahren zur Herstellung der bekannten Kühleinrichtungen aufwendig, denn es muß ein Grundkörper aus Wachs hergestellt werden, in welchen zunächst Kupfer-Trennwände eingebracht werden. Anschließend wird dieser Körper vollständig mit einer Kupferschicht überzogen. Danach wird die Kupferschicht an zwei gegenüberliegenden Seiten wieder entfernt und in einem letzten Schritt wird der Wachs entfernt, so daß dann die Kanäle der Kühleinrichtung übrig bleiben.

Schließlich ist durch das Dokument US 4 706 164 eine aus mehreren Platten bestehende Anordnung bekannt, bei welcher zur Kühlung einer gedruckten Schaltung, die auch als Multi-Layer ausgebildet sein kann, eine Kühlplatte als unterste Platte der Anordnung vorgesehen ist, während die Leiterplatte die oberste Platte bildet.

In der Kühlplatte befinden sich Kühlkanäle, die mittels einer Dichtungsplatte abgedichtet sind. An diese Dichtungsplatte schließt sich zur mechanischen Stabilisierung der gesamten Anordnung eine Stabilisierplatte aus Metall an, und auf die Stabilisierplatte ist eine Isolierplatte gelegt, auf der sich wiederum die Leiterplatte befindet. Die gesamte Leiterplattenanordnung wird mechanisch durch Schraubverbindungen zusammengehalten. Auch diese bekannte Anordnung erfordert einen großen Aufwand. Nachteilig ist ferner, daß die Kühlplatte relativ weit von der Wärmequelle entfernt ist.

Eine Leiterplattenanordnung ist ferner aus DE-A-4012100 bekannt.

Der Erfindung liegt die Aufgabe zugrunde, eine Leiterplattenanordnung zu schaffen, bei welcher eine Kühlung mit einem entscheidend verbesserten Wirkungsgrad erzielt wird, ohne daß großvolumige Kühlkörper erforderlich sind, die den gesamten Platzbedarf einer Leiterplattenanordnung im konkreten Anwendungsfall nachteilig vergrößern, und bei welcher die Herstellung des Kühlkörpers vereinfacht ist.

Die Lösung dieser Aufgabe erfolgt durch die Merkmale des Patentanspruchs 1.

Bei der Leiterplattenanordnung gemäß Anspruch 1 ist die Kühlplatte mit mindestens einem Kühlkanal versehen, und zu beiden Seiten der Kühlplatte ist mindestens eine Leiterplatte angeordnet, so daß die Kühlplatte ein integrierter Bestandteil der gesamten Leiterplattenanordnung ist. Die Kühlplatte besteht aus einer auf einer isolierenden Trägerschicht angeordneten wärmeleitenden Kühlschicht, und der Kühlkanal verläuft als einseitig offener Kanal in der Kühlschicht und wird durch eine als Bestandteil zur gesamten Kühlplatte gehörende Isolierplatte abgedeckt, wodurch der Kühlkanal als geschlossener Kanal ausgebildet wird.

Die Kühlschicht besteht aus Kupfer oder Aluminium und der Kühlkanal ist durch Ätzen oder Prägen als einseitig offener Kanal in der Kühlschicht erzeugt und die Trägerschicht ist als vollflächig ebene Platte ausgebildet.

Von ihren äußeren Abmessungen her kann die Kühlplatte wie die Leiterplatten der Leiterplattenanordnung gestaltet sein, so daß die Kühlplatte einfach eine weitere Schicht bei einem Multi-Layer bildet. Dies ist von besonderem Vorteil hinsichtlich der Gesamtabmessungen, denn im Vergleich zu großflächigen und großvolumigen Kühlkörpern fällt eine zusätzliche Schicht für die Kühlplatte kaum ins Gewicht.

Der Grundgedanke der Erfindung besteht darin, mit der Kühlplatte ein inneres und ein aktives Kühlsystem bei einer Leiterplattenanordnung zu bilden und die Wärme über die Kühlplatte und über die in der Kühlplatte verlaufenden Kühlkanäle bzw. über das darin befindliche Kühlmedium abzuführen. Dabei ist es denkbar, außerhalb der Leiterplattenanordnung, wo mehr Platz zur Verfügung steht, eine kleine Pumpe mit einem Wärmetauscher anzuordnen, um eine optimale Kühlung zu erzielen, und zwar mit einem deutlich besseren Wirkungsgrad als bei herkömmlichen Kühlkörpern.

Ein weiterer Vorteil besteht auch darin, daß sich die Kühlplatte über die gesamte Leiterplattenanordnung erstreckt und somit auch im gesamten Bereich eine Kühlung erfolgen kann. Dabei ist es ohne weiteres möglich, mehrere Kühlkanäle vorzusehen und diese insbesondere in den Bereichen anzuordnen, auf denen sich auf der Leiterplatte Leistungsbauelemente befinden, die besonders viel Wärme erzeugen. Durch einen schlangenlinienförmigen Verlauf kann man in Bereichen, in denen besonders viel Wärme anfällt, eine große Länge des Kühlkanals erreichen, der von dem Kühlmedium durchströmt wird, so daß dort auch besonders viel Wärme abgeführt werden kann.

Bei der Erfindung erfolgt eine aktive Kühlung in Form einer reinen Wärmeübertragung durch die Verwendung von mit einem Kühlmedium gefüllten bzw. durchflossenen Kühlkanal. Der Wärmeübergang, also die Kühlung, ist dabei direkt an der verursachenden Quelle vorgesehen, wobei der Wärmeübergang zweistufig erfolgt. In der ersten Stufe wird die Wärme von der Kühlplatte und in der zweiten Stufe von dem Kühlmedium in den Kühlkanälen aufgenommen, die sich in der Kühlplatte erstrekken.

In vorteilhafter Weise wird die Kühlplatte in den Multi-Layer-Aufbau integriert, so daß die Kühlplatte einen integralen Bestandteil der Leiterplattenanordnung darstellt. Da bei einem Multi-Layer mit mehreren übereinander angeordneten Leiterplatten zwischen den einzelnen Leiterplatten bekanntlich jeweils eine Isolierplatte als Prepreg vorgesehen wird, wird im Grunde genommen dabei dieser Prepreg einfach durch die integrierte Kühlschicht ersetzt, die aus der Kühlplatte besteht, die zu beiden Seiten eine Isolierplatte besitzt.

Ein besonderer Vorteil der Erfindung besteht auch noch darin, daß sich die Herstellung der Kühlplatte problemlos mit dem Herstellungsprozeß der Leiterplatte kombinieren läßt, denn aus fertigungstechnischer Sicht kann die Kühlplatte einfach als eine zu bearbeitende Leiterplatte angesehen werden. Hierbei befindet sich auf der Trägerschicht die aus wärmeleitendem Material bestehende Kühlschicht, z. B. aus Kupfer. Durch einfaches Ätzen - wie bei der Herstellung von gedruckten Leiterplatten - lassen sich die Kühlkanäle durch Entfernen von Kupfer an den betreffenden Stellen bilden, die dann noch einseitig offen sind. Anschließend wird auf die Kühlschicht eine Isolierplatte gelegt, so daß die offenen Kühlkanäle abgedeckt und zu geschlossenen Kühlkanälen werden. Als Isolierplatte kann dabei in an sich bekannter Weise das schon erwähnte Prepeg verwendet werden, was einen weiteren Vorteil der Erfindung bedeutet.

In einer weiteren zweckmäßigen Ausgestaltung der Erfindung bildet der Kühlkanal einen in sich geschlossenen Kanal. Diese Maßnahme läßt sich mit Erfolg anwenden, wenn nur geringe Kühlleistungen erforderlich sind.

In einer anderen vorteilhaften Weiterbildung der Erfindung besitzt der mindestens eine Kühlkanal einen Eingang und einen Ausgang, und ferner ist eine externe Pumpe vorgesehen, mit welcher das Kühlmedium durch den Kühlkanal gefördert wird. Diese Maßnahme wird man bevorzugt bei größeren Kühlleistungen anwenden, und in einer weiteren zweckmäßigen Ausgestaltung der Erfindung ist dabei auch noch vorgesehen, das Kühlmedium mittels der Pumpe über einen Wärmetauscher zu führen. Dabei sind sowohl der Wärmetauscher als auch die Pumpe außerhalb der Leiterplattenanordnung angeordnet, so daß für die Leiterplattenanordnung selbst kein zusätzlicher Platzbedarf erforderlich ist.

Als Kühlmedium kann in zweckmäßiger Weise Luft, Wasser oder flüssiger Stickstoff verwendet werden, und das wärmeleitende Material der Kühlplatte läßt sich durch Kupfer oder durch Aluminium bilden.

Gemäß einer besonders vorteilhaften Ausgestaltung der Erfindung ist mindestens eine Leiterbahn einer Leiterplatte teilweise großflächig als Kühlmetallschicht ausgebildet, die in einer wärmeleitenden Verbindung mit der wärmeleitenden Kühlschicht und/oder mit dem Kühlmedium steht.

Man kann also an der Stelle einer Leiterplatte, an der sich ein wärmeerzeugendes Bauelement befindet, die normalerweise schmal verlaufende Leiterbahn großflächig ausbilden, wobei diese große Fläche für sich dann eine Kühlmetallschicht bildet. Bereits dadurch wird direkt an dem Ort, an dem die Wärme erzeugt wird, eine gewisse Kühlung erreicht. Der Kühleffekt wird in vorteilhafter Weise dadurch unterstützt, daß diese Kühlmetallschicht in wärmeleitender Verbindung mit der wärmeleitenden Kühlschicht und/oder mit dem Kühlmedium der Kühlplatte steht. Zweckmäßigerweise wird man im Bereich dieser Kühlmetallschicht möglichst viele Kühlkanäle innerhalb der Kühlplatte anordnen, beispielsweise durch einen schlangenlinienförmigen Verlauf, um im Bereich der Kühlmetallschicht eine große Länge der Kühlkanäle zu erzielen. Normalerweise erfolgt der Wärmeübergang über die Isolierplatte zur Kühlplatte, wobei der Wärmewiderstand der Isolierplatte (Prepeg) beim Wärmetransport überwunden werden muß.

Durch die Kühlmetallschicht wird nun der Wärmeübergang zur Kühlplatte und zum Kühlmedium entscheidend verbessert, da die Kühlmetallschicht direkt in wärmeleitender Verbindung mit der Kühlplatte und dem Kühlmedium steht und der vergleichsweise große Wärmewiderstand der Isolierplatte nicht mehr überwunden zu werden braucht.

In zweckmäßiger Ausgestaltung der Erfindung wird die wärmeleitende Verbindung durch Bohrungen gebildet, welche die Leiterplatte und die Kühlplatte durchdringen, wobei die Innenwandungen der Bohrungen mit einem Wärmeleitmaterial versehen sind.

Die Erfindung befaßt sich auch noch mit einem Verfahren zur Herstellung einer Leiterplattenanordnung nach einem der Ansprüche 1 bis 7, wobei die Erfindung vorsieht, daß der Kühlkanal durch Ätzen einer metallischen Kühlschicht aus Kupfer oder Aluminium, die auf einer vollflächig ebenen Trägerschicht angebracht ist, erzeugt wird.

Alternativ schlägt die Erfindung ein Verfahren zur Herstellung einer Leiterplattenanordnung nach einem der Ansprüche 1 bis 7 vor, bei welchem der Kühlkanal durch Prägung einer metallischen Kühlschicht aus Kupfer oder Aluminium, die auf einer vollflächig ebenen Trägerschicht angeordnet ist, erzeugt wird.

Beide Verfahrensschritte stellen Maßnahmen dar, wie sie grundsätzlich bei der Herstellung gedruckter Leiterplatten zur Anwendung gelangen, so daß man die benötigte Kühlplatte integriert mit der Herstellung der gesamten Leiterplattenanordnung als Multi-Layer herstellen kann.

Anhand der in der Zeichnung dargestellten Ausführungsbeispiele wird die Erfindung nachfolgend näher erläutert. Es zeigen:
- Fig. 1: eine Querschnittsansicht eines Teiles einer Leiterplattenanordnung mit einer Kühlplatte,
- Fig. 2: eine perspektivische Ansicht einer Leiterplattenanordnung gemäß Fig. 1 in explodierter Darstellung,
- Fig. 3: eine Draufsicht auf eine Leiterplattenanordnung mit zwei Kühlmetallschichten,
- Fig. 4: eine Teil-Querschnittsansicht der Anordnung gemäß Fig. 3, und
- Fig. 5: eine schematische Darstellung einer Leiterplattenanordnung mit einem externen Wärmetauscher.

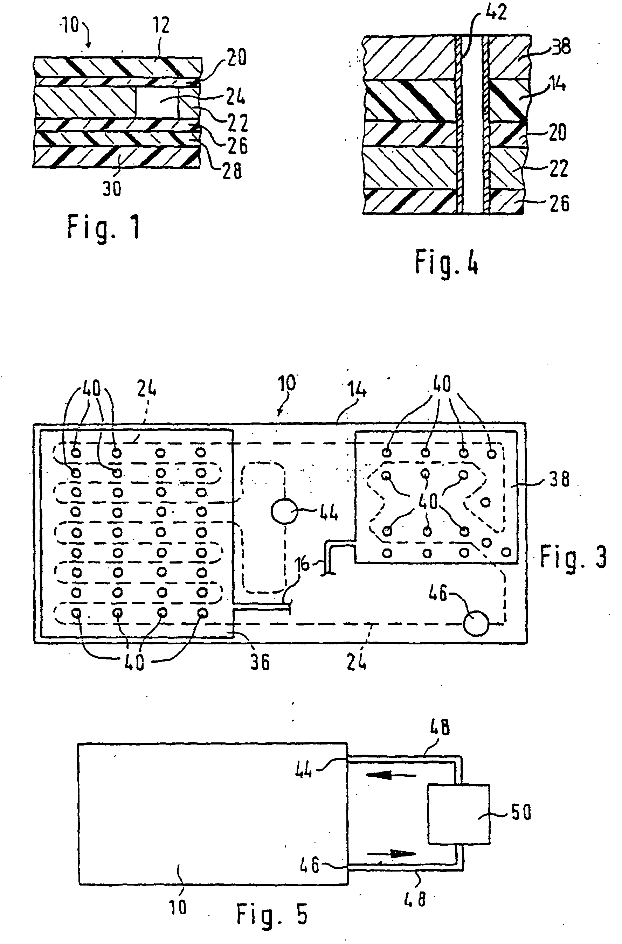

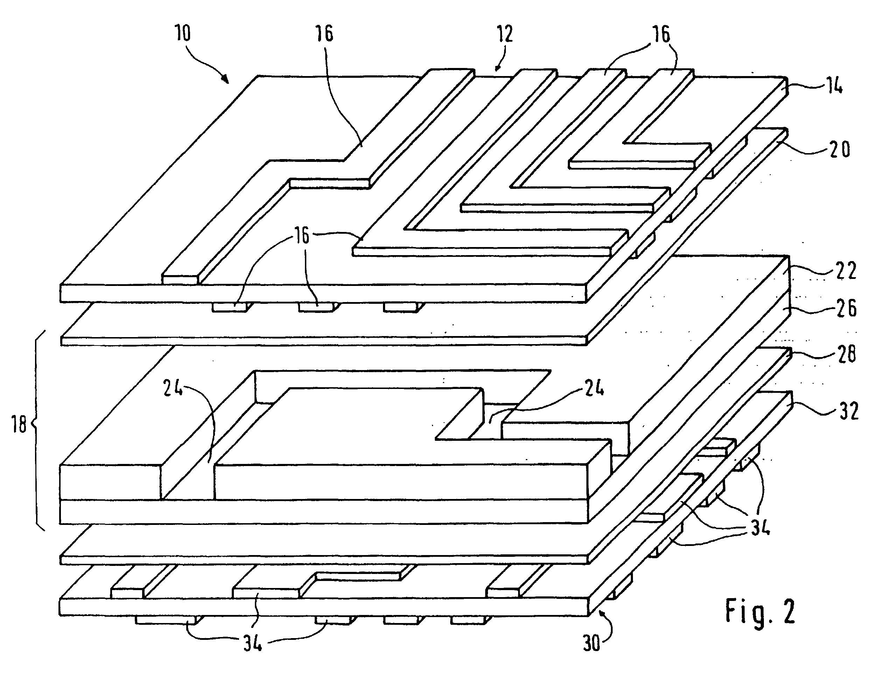

Gemäß Fig. 1 und 2 umfaßt die Leiterplattenanordnung 10 eine Leiterplatte 12 mit einem Träger 14. Der Träger 14 ist beidseitig mit elektrischen Leiterbahnen 16 bedruckt, wobei sich oben die Bestückungsseite befindet.

An die Leiterplatte 12 schließt sich nach unten hin als Isolierplatte 20 ein Prepreg an, und darunter befindet sich eine Kühlschicht 22 aus Kupfer, welches als Kupferschicht auf einer Trägerschicht 26 angeordnet ist.

Innerhalb der Kühlschicht 22 erstreckt sich ein Kühlkanal 24. Die Herstellung des Kühlkanals 24 kann in einfacher Weise durch Ätzen erfolgen, also durch Entfernen des Kupfers im Bereich des Kühlkanals 24. Es ist auch möglich, den Kühlkanal 24 in einer Prägetechnik durch Prägen herzustellen. Dabei ist der Kühlkanal 24 zunächst nach oben hin offen. Durch die Isolierplatte 20 wird der Kühlkanal 24 im fertigen Zustand der gesamten Leiterplattenanordnung 10 abgedeckt und zu einem geschlossenen Kühlkanal. Die Isolierplatte 20 läßt sich in vorteilhafter Weise in Form eines Prepreg zum Verbinden der Leiterplatte 14 mit der Kühlschicht 22 verwenden. Die Kühlschicht 22 mit dem Kühlkanal 24 sowie die als Isolierschicht ausgebildete Trägerschicht 26 und die Isolierplatte 20 bilden insgesamt eine Kühlplatte 18 innerhalb der Leiterplattenanordnung 10.

An die Kühlplatte 18 bzw. an die Trägerschicht 26 schließen sich als Isolierplatte ein Prepreg 28 sowie eine Leiterplatte 30 mit einem Träger 32 an. Der Träger 32 ist oben und unten mit elektrischen Leiterbahnen 34 versehen, wobei die untere Seite des Trägers 32 die Lötseite bildet. Da die Trägerschicht 26 bereits als Isolierplatte ausgebildet ist, ist es auch möglich auf die weitere Isolierplatte in Form des Prepregs 28 zu verzichten, denn die Trägerschicht 26 kann die Funktion des Prepregs 28 mit übernehmen.

Fig. 3 zeigt in einer Draufsicht eine Leiterplatte 10, auf deren Träger 14 zwei Leiterbahnen 16 in Teilbereichen großflächig ausgebildet sind und eine Kühlmetallschicht 36 und eine weitere Kühlmetallschicht 38 bilden. In der Leiterplatte 10 befinden sich zwei die Kühlplatte 18 durchdringende Bohrungen, die für die Kühlkanäle 24 einen Eingang 44 und eine Ausgang 46 bilden, um mittels einer hier nicht dargestellten externen Pumpe einen Kreislauf für ein Kühlmedium durch die Kühlkanäle 24 herzustellen (vgl. auch Fig. 5).

Im Bereich der Kühlmetallschichten 36 und 38 verlaufen die Kühlkanäle 24 derart, daß sich dort eine möglichst große Länge der Kühlkanäle und damit eine möglichst große Verweildauer des Kühlmediums im Bereich der Kühlmetallschichten 36 und 38 ergibt. So erstreckt sich der Kühlkanal 24 im Bereich der Kühlmetallschicht 36 schlangenlinienförmig. Dadurch wird eine besonders gute Wärmeableitung erreicht.

Die Kühlmetallschichten 36 und 38 stehen über Bohrungen 40 in wärmeleitender Verbindung mit der Kühlschicht 22, wie dies anhand der Teil-Querschnittsansicht gemäß Fig. 4 für die Kühlmetallschicht 38 verdeutlicht ist. Die Innenwandungen der Bohrungen 40 sind mit einem Wärmeleitmaterial 42 nach Art einer Innenhülse versehen, wodurch eine Durchkontaktierung von der Kühlmetallschicht 38 zur Kühlschicht 22 hergestellt wird.

Während normalerweise beim Wärmeübergang zur Kühlschicht 22 der Wärmewiderstand der Isolierplatte 20 überwunden werden muß, wird in Fig. 3 die von den Kühlmetallschichten 36 und 38 aufgenommene Wärme direkt über die wärmeleitenden Verbindungen in Form der Bohrungen 40 zur Kühlschicht 22 geführt.

Die schematische Darstellung in Fig. 5 zeigt eine Leiterplattenanordnung 10, bei welcher der Eingang 44 und der Ausgang 46 der Kühlschicht 18 über Leitungen 48 mit einem externen Wärmetauscher 50 mit einer Pumpe verbunden sind, um ein Kühlmedium durch die Kühlkanäle 24 zu fördern. Selbstverständlich können gleichzeitig auch mehrere Leiterplattenanordnungen bzw. mehrere Kühlschichten an den Wärmetauscher 50 angeschlossen werden. Der dabei erzielte Wirkungsgrad für die Kühlung liegt um ein Vielfachers höher als bei Verwendung von herkömmlichen großvolumigen und unhandlichen Kühlkörpern.

## Patentansprüche

1. Leiterplattenanordnung (10) mit mindestens zwei Leiterplatten (12; 30), die einseitig oder beidseitig mit elektrischen Leiterbahnen (16; 34) versehen und mit Wärme erzeugenden Bauelementen bestückt sind, und mit mindestens einer Kühlplatte (18), die zu beiden Seiten über eine elektrisch isolierende Klebeschicht mit mindestens einer Leiterplatte (12; 30) verbunden ist, wobei die Kühlplatte mit mindestens einem Kühlkanal (24) versehen ist, wobei die Kühlplatte (18) aus einer elektrisch isolierenden Trägerschicht (26) und einer einseitig auf dieser angeordneten wärmeleitenden Kühlschicht (22) aus Kupfer oder Aluminium besteht, wobei der Kühlkanal (24) durch Ätzen oder Prägen als einseitig offener Kanal in der Kühlschicht (22) erzeugt ist und die Trägerschicht (26) als vollflächig ebene Platte ausgebildet ist.

2. Leiterplattenanordnung nach Anspruch 1, **dadurch gekennzeichnet, dass** der Kühlkanal (24) einen in sich geschlossenen Kanal bildet.

3. Leiterplattenanordnung nach Anspruch 1 oder 2, **dadurch gekennzeichnet, dass** der Kühlkanal (24) einen Eingang (44) und einen Ausgang (46) besitzt, und dass eine externe Pumpe vorgesehen ist, mit welcher ein Kühlmedium durch den Kühlkanal (24) gefördert wird.

4. Leiterplattenanordnung nach einem der Ansprüche 1 bis 3, **dadurch gekennzeichnet, dass** das Kühlmedium mittels der Pumpe einen Wärmeaustauscher (50) durchströmt.

5. Leiterplattenanordnung nach einem der Ansprüche 1 bis 4, **dadurch gekennzeichnet, dass** das Kühlmedium durch Luft, Wasser oder flüssigen Stickstoff gebildet ist.

6. Leiterplattenanordnung nach einem der Ansprüche 1 bis 5, **dadurch gekennzeichnet, dass** mindestens eine Leiterbahn (16; 34) einer Leiterplatte (12; 30) teilweise großflächig als Kühlmetallschicht (36, 38) ausgebildet ist, und dass die Kühlmetallschicht (36, 38) in wärmeleitender Verbindung mit der wärmeleitenden Kühlschicht (22) und/oder mit dem Kühlmedium steht.

7. Leiterplattenanordnung nach Anspruch 6, **dadurch gekennzeichnet, dass** die wärmeleitende Verbindung durch die Leiterplatte (12) und die Kühlplatte (18) durchdringende Bohrungen (40) gebildet ist, deren Innenwandungen mit einem Wärmeleitmaterial (42) versehen sind.

8. Verfahren zur Herstellung einer Leiterplattenanordnung nach einem der Ansprüche 1 bis 7, **dadurch gekennzeichnet, dass** der Kühlkanal (24) durch Ätzen einer metallischen Kühlschicht (22) aus Kupfer oder Aluminium, die auf einer vollflächig ebenen Trägerschicht (26) angebracht ist, erzeugt wird.

9. Verfahren zur Herstellung einer Leiterplattenanordnung nach einem der Ansprüche 1 bis 8, **dadurch gekennzeichnet, dass** der Kühlkanal (24) durch Prägung einer metallischen Kühlschicht (22) aus Kupfer oder Aluminium, die auf einer vollflächig ebenen Trägerschicht (26) angeordnet ist, erzeugt wird.

## Claims

1. Printed circuit board assembly (10) with at least two printed circuit boards (12; 30), provided on one or both sides with electrical conductor tracks (16; 34) and assembled with heat-generating components, and having at least one cooling plate (18) connected on both sides by means of an electrically insulating adhesive coating to at least one printed circuit board (12; 30), the cooling plate being provided with at least one cooling channel (24), the cooling plate (18) comprising an electrically insulating support layer (26) and a copper or aluminium, heat conducting cooling layer (22) arranged on one side of the latter, the cooling channel (24) being produced by etching or embossing as a channel open on one side in said cooling layer (22) and the support layer (26) is constructed as a full-surface, planar plate.

2. Printed circuit board assembly according to claim 1, **characterized in that** the cooling channel (24) forms a self-contained channel.

3. Printed circuit board assembly according to claim 1 or 2, **characterized in that** the cooling channel (24) has an inlet (44) and an outlet (46) and that an external pump is provided with which a cooling medium is delivered through the cooling channel (24).

4. Printed circuit board assembly according to one of the claims 1 to 3, **characterized in that** by means of the pump, the cooling medium flows through a heat exchanger (50).

5. Printed circuit board assembly according to one of the claims 1 to 4, **characterized in that** the cooling medium is formed by air, water or liquid nitrogen.

6. Printed circuit board assembly according to one of the claims 1 to 5, **characterized in that** at least one conductor track (16; 34) of a printed circuit board (12; 30) is in part constructed in large-surface manner as a cooling metal layer (36, 38) and that the cooling metal layer (36, 38) is in heat conducting connection with the heat conducting cooling layer (22) and/or with the cooling medium.

7. Printed circuit board assembly according to claim 6, **characterized in that** the heat conducting connection is formed by holes (40) penetrating the printed circuit board (12) and cooling plate (18) and whose inner walls are provided with a heat conducting material (42).

8. Method for the manufacture of a printed circuit board assembly according to one of the claims 1 to 7, **characterized in that** the cooling channel (24) is produced by etching a metallic cooling layer (22) of copper or aluminium, which is applied to a full-surface, planar support layer (26).

9. Method for the manufacture of a printed circuit board assembly according to one of the claims 1 to 8, **characterized in that** the cooling channel (24) is produced by embossing a metallic cooling layer (22) of copper or aluminium located on a full-surface, planar support layer (26).

## Revendications

1. Arrangement de plaquettes (10) comprenant deux plaquettes au moins (12, 30), qui sont pourvues de pistes conductives électriques (16, 34) sur une face ou sur les deux faces et équipées de composants calorifiques, et une plaque de refroidissement (18) au moins, qui est reliée sur les deux côtés à une plaquette (12, 30) au moins, par l'intermédiaire d'une couche de colle isolante électrique, la plaque de refroidissement étant pourvue d'un canal de refroidissement (24) au moins et constituée d'une couche porteuse (26) isolante électrique, sur une face de laquelle est disposée une couche de refroidissement (24) thermoconductrice en cuivre ou en aluminium, le canal de refroidissement (24) étant réalisé par gravure ou frappe en forme de canal ouvert sur un côté dans la couche de refroidissement (22) et la couche porteuse (26) étant conçue en forme de plaque de surface entièrement plane.

2. Arrangement de plaquettes suivant la revendication 1, **caractérisé en ce que** le canal de refroidissement (24) forme un canal fermé en soi.

3. Arrangement de plaquettes suivant la revendication 1 ou 2, **caractérisé en ce que** le canal de refroidissement (24) possède une entrée (44) et une sortie (46) et qu'une pompe externe est prévue, au moyen de laquelle un agent réfrigérant est débité à travers le canal de refroidissement (24).

4. Arrangement de plaquettes suivant une des revendications 1 à 3, **caractérisé en ce qu**'au moyen de la pompe, l'agent réfrigérant traverse un échangeur thermique (50).

5. Arrangement de plaquettes suivant une des revendications 1 à 4, **caractérisé en ce que** l'agent réfrigérant est de l'air, de l'eau ou de l'azote.

6. Arrangement de plaquettes suivant une des revendications 1 à 5, **caractérisé en ce qu**'au moins une piste conductrice (16, 34) d'une plaquette (12, 30) est conçue partiellement sur une grande surface comme une couche métallique de refroidissement (36, 38) et en ce que la couche métallique de refroidissement (36, 38) est reliée, de manière thermoconductrice, à la couche de refroidissement thermoconductrice (22) et/ou à l'agent réfrigérant.

7. Arrangement de plaquettes suivant la revendication 6, **caractérisé en ce que** la liaison thermoconductrice est formée par des trous (40), dont la paroi interne est pourvue d'une matière thermoconductrice (42), forés à travers la plaquette (12) et la plaque de refroidissement (18).

8. Procédé de fabrication d'un arrangement de plaquettes suivant une des revendications 1 à 7, **caractérisé en ce que** le canal de refroidissement (24) est réalisé par gravure d'une couche métallique de refroidissement (22) en cuivre ou en aluminium, qui est fixée sur une couche porteuse (26) à surface entièrement plane.

9. Procédé de fabrication d'un arrangement de plaquettes suivant une des revendications 1 à 8, **caractérisé en ce que** le canal de refroidissement (24) est réalisé par frappe d'une couche métallique de refroidissement (22) en cuivre ou en aluminium, qui est disposée sur une couche porteuse (26) à surface entièrement plane.
